# EUROPÄISCHE PATENTSCHRIFT

(11) **EP 2 596 162 B1**
(45) Veröffentlichungstag und Bekanntmachung des Hinweises auf die Patenterteilung: **21.08.2019**
(21) Anmeldenummer: 11748461.8
(22) Anmeldetag: 05.07.2011
(51) Int. Cl.: D06F 75/26, D06F 75/08, D06F 75/34, H03K 17/94

(54) **ELEKTRISCH BEHEIZBARES GERÄT, INSBESONDERE BÜGELEISEN, UND VERFAHREN ZUR STEUERUNG EINES SOLCHEN GERÄTS**
ELECTRIC HOUSEHOLD APPLIANCE, IN PARTICULAR A PRESSING IRON, AND METHOD FOR CONTROLLING SAME
APPAREIL ÉLECTROMÉNAGER, EN PARTICULIER UN FER À REPASSER, ET PROCÉDÉ DE COMMANDE DU MÊME

(30) Priorität: 24.09.2010 DE 102010041342; 21.07.2010 ES 201031118
(43) Veröffentlichungstag der Anmeldung: 29.05.2013
(73) Patentinhaber: SDA FACTORY VITORIA SLU, 01010 Vitoria Gasteiz Araba (ES)
(72) Erfinder: ALBANDOZ RUIZ DE OCENDA, Carmelo, E-01006 Vitoria (ES); LAVEZZARI, Stefano, E-01010 Vitoria (ES)
(74) Vertreter: Herrero & Asociados, S.L.
(86) Internationale Anmeldenummer: PCT/IB2011/052966
(87) Internationale Veröffentlichungsnummer: WO 2012/011006

(56) Entgegenhaltungen:
- EP-A1- 0 390 264
- WO-A2-96/34510
- US-A- 5 719 379

## Beschreibung

### Hintergrund der Erfindung

Die Erfindung betrifft ein Verfahren zur Steuerung eines elektrisch beheizbaren Geräts, insbesondere eines Haushaltsgeräts, z.B. eines Bügeleisens, bei dem in Abhängigkeit von einem Benutzungszustand des Geräts eine Nichtbenutzung ermittelt wird und die elektrische Heizung des Geräts deaktiviert werden kann, wenn die Zeitdauer der Nichtbenutzung einen ersten zeitlichen Schwellenwert erreicht hat. Die Erfindung betrifft ferner ein elektrisch beheizbares Gerät, insbesondere ein Bügeleisen, mit einer elektrischen Heizung und einer mit dieser zusammenwirkenden elektrischen Schaltung sowie mit einem Sensor zur Erzeugung einer Nichtbenutzung, wobei die elektrische Schaltung ein Zeitglied aufweist, welches zur Bestimmung der Zeitdauer der Nichtnutzung und deren Vergleich mit einem ersten zeitlichen Schwellenwert geeignet ist.

### Stand der Technik

Die Verwendung von Bügeleisen zum Glätten von Textilien oder ähnlichen Flächengebilden im privaten und kommerziellen Bereich ist gängige Praxis. Dabei wird eine ebene, glatte Oberfläche des Bügeleisens erhitzt und manuell auf das zu glättende Flächengebilde aufgesetzt. Durch Druck und Bewegung des Bügeleisens relativ zu dem Flächengebilde, häufig unterstützt durch gleichzeitige Dampfzufuhr, werden Falten aus dem Flächengebilde entfernt. Dabei wird die Bügeltemperatur zum Erzielen eines guten Glätteffekts innerhalb einer möglichst kurzen Zeit üblicherweise so gewählt, dass das Flächengebilde bei der vorgesehenen Kontaktzeit mit der erhitzten Oberfläche des Bügeleisens gerade nicht geschädigt wird. Die Temperatur wird in der Regel durch einen mechanischen Thermostaten geregelt, durch welchen die Stromzufuhr zum Heizelement des Bügeleisens in Abhängigkeit von der gemessenen Temperatur geöffnet oder geschlossen wird.

Bei Nichtbenutzung kann ein erhitztes Bügeleisen grundsätzlich eine Gefahrenquelle darstellen. Liegt das Bügeleisen unbewegt für längere Zeit auf dem zu glättenden Flächengebilde auf, kann dieses thermisch geschädigt werden oder sogar in Brand geraten. Ein hochkant gestelltes und dadurch nicht mehr thermisch auf das Flächengebilde einwirkendes Bügeleisen hingegen kann um- oder von der Arbeitsfläche herunterfallen und hierdurch Verbrennungen erzeugen oder eine Brandquelle darstellen. Daher werden hochwertige Bügeleisen oft mit einer Sicherheitsschaltung ausgestattet, die den zuvor genannten Gefahren entgegenwirkt.

Aus der internationalen Patentanmeldung WO 95/32551 A1 ist ein gattungsgemäßes Verfahren zur Steuerung eines Bügeleisens bekannt. Das dort offenbarte Bügeleisen besteht aus einer metallischen Grundplatte, beispielsweise aus Aluminium, welche mittels einer elektrischen Widerstandsheizung erhitzt werden kann und durch eine Isolierplatte von dem aus Kunststoff spritzgegossenen Gehäuse thermisch getrennt ist. Das Gehäuse besteht aus einem Aufnahmebereich für die Grundplatte, einem Griffstück und einem Sockelteil, in welches das Netzkabel zum Anschluss an ein übliches Wechselstromnetz einmündet. Zwischen Sockelteil und Griffstück ist eine Leiterplatte eingelassen, welche eine elektrische Schaltung zur Regelung des Bügeleisens ausbildet. Das Gehäuse ist außerdem mit einer Anzahl von Bedienelementen zur Benutzungssteuerung, beispielsweise zur Einstellung der Bügeltemperatur und einer möglichen Dampferzeugung, ausgestattet. Im Griffteil ist ferner ein berührungsempfindlicher Schalter angeordnet, der beim Fassen des Griffs aktiviert wird und ein Signal hinsichtlich Benutzung oder Nichtbenutzung des Bügeleisens erzeugt, welches an die elektrische Schaltung weitergeleitet wird. Ferner sind Mittel zur Regelung der Betriebstemperatur der Grundplatte in Abhängigkeit vom Temperatursollwert vorgesehen.

Sobald der Benutzer das Bügeleisen am Griffstück fasst, werden der berührungsempfindliche Schalter aktiviert und die elektrische Widerstandsheizung eingeschaltet. Diese bleibt in Betrieb, solange das Bügeleisen am Griffstück gehalten wird. Gibt der Benutzer das Griffstück frei, wird vom berührungsempfindlichen Schalter ein entsprechendes Signal für die elektrische Schaltung des Bügeleisens erzeugt. Nach einer vorgegebenen Zeitdauer, beispielsweise nach 30 Sekunden ab Freigabe des Griffstücks, wird die elektrische Widerstandsheizung abgeschaltet, wodurch sich die Grundplatte des Bügeleisens allmählich abkühlt. Wird das Griffstück erneut vom Benutzer berührt, schaltet sich das Heizelement unverzüglich wieder ein.

Um zu vermeiden, dass der Benutzer das Griffstück beim erstmaligen Aufheizen des Bügeleisens zu Beginn des Bügelvorgangs solange fassen muss, bis die gewählte Bügeltemperatur erreicht ist, erfolgt beim erstmaligen Anschluss des Bügeleisens an das Stromnetz ein Aufheizen über eine bestimmte Zeitdauer auch dann, wenn der Benutzer das Griffstück nach dieser Berührung wieder frei gibt. Diese Zeitdauer kann beispielsweise zwei Minuten betragen. Lässt der Benutzer jedoch innerhalb der nächsten 30 Sekunden nicht durch Greifen des Griffstücks erkennen, dass ein Bügelvorgang eingeleitet wurde, schaltet sich die elektrische Widerstandsheizung erneut ab.

Dieses Verfahren zur Steuerung eines Bügeleisens weist den Nachteil auf, dass bei einer längeren Nichtbenutzung ohne Netztrennung das nunmehr abgekühlte Bügeleisen nur dann wieder auf Betriebstemperatur gebracht werden kann, wenn das Benutzer das Griffstück entsprechend lang hält. In dieser Zeit kann das Bügeleisen wegen der zu geringen Temperatur naturgemäß nicht verwendet werden, sondern bindet den im Übrigen untätigen Benutzer.

Eine weitere Sicherheitseinrichtung an einem elektrischen Bügeleisen wird in der Offenlegungsschrift DE 195 42 916 A1 offenbart. Auch bei diesem Bügeleisen ist im von der Bedienperson zu greifenden Teil des Gehäuses ein Sensor angeordnet, welcher mit einem Sicherheitsschaltelement im Stromkreis des Bügeleisens zusammenwirkt und die Stromzufuhr unterbricht, wenn die Bedienperson den Kontakt zum Bügeleisen löst. Die Unterbrechung der Stromzufuhr kann unverzüglich oder beim Vorhandensein einer Zeitverzögerungseinrichtung, beispielsweise eines Bimetall-Elements, unmittelbar danach erfolgen. Geeignete Sensoren sind beliebige Tast- und Druckschalter, Lichtschranken, Fotozellen und Infrarot-Zellen oder dergleichen. Auf einen Ein/Aus-Schalter wird verzichtet.

Die britische Patentanmeldung GB 2 199 962 A beschreibt ein weiteres Bügeleisen mit einer Sicherheitseinrichtung, welche die Stromzufuhr zum Bügeleisen nach einer vorgegebenen Zeitdauer unterbricht oder auf ein niedrigeres Sicherheitsniveau reduziert, wenn der Benutzer das Bügeleisen aus der Hand gibt. Zur Erfassung des Benutzungszustands wird in diesem Fall ein kapazitiver Näherungssensor verwendet. Um eine eindeutige Ein-/Ausschaltfunktion zu gewährleisten, wird der Steuerung des Bügeleisens zusätzlich zum Signal des Näherungssensors ein weiteres Signal übermittelt, welches mit einem Schwellenwert, beispielsweise für eine Spannung in einem Kondensator, verglichen wird und beim Über- oder Unterschreiten dieses Schwellenwerts die Stromzufuhr unterbricht oder einschaltet. Der Kondensator wird während der nur kurzfristig unterbrochenen Handhabung des Bügeleisens zyklisch geladen und überschreitet dabei regelmäßig den Schwellenwerts von 2,5 Volt. Infolge dieser Signale schaltet ein Triac die Stromzufuhr zum Heizelement ein. Wird das Bügeleisen nicht mehr benutzt, verharrt der Triac über eine vorgegebene Zeitdauer in seiner Freigabestellung, unterbricht die Stromzufuhr jedoch nachfolgend. Die Abschaltung wird der Bedienperson durch ein Lichtsignal mitgeteilt.

Das Dokument WO 96/34510 A2 offenbart ein Verfahren zur Steuerung eines elektrisch beheizbaren Geräts, bei dem in Abhängigkeit von einem Benutzungszustand des Geräts eine Nichtbenutzung ermittelt wird und die elektrische Heizung des Geräts deaktiviert werden kann, wenn die Zeitdauer der Nichtbenutzung einen ersten zeitlichen Schwellenwert erreicht hat.

Das Dokument US 5,719,379 offenbart ein elektrisch beheizbares Haushaltsgerät, mit einer elektrischen Heizung und einer mit dieser zusammenwirkenden elektrischen Schaltung sowie mit einem Sensor zur Erkennung einer Nichtbenutzung, wobei die elektrische Schaltung ein Zeitglied aufweist, welches zur Bestimmung der Zeitdauer der Nichtbenutzung und deren Vergleich mit einem ersten zeitlichen Schwellenwert geeignet ist.

Im Übrigen sei noch auf die WO 2006/34510 A2 hingewiesen.

Auch diese Bügeleisen sind hinsichtlich ihrer Handhabung nach einer längeren Unterbrechung der Benutzung unkomfortabel.

### Der Erfindung zugrundeliegende Aufgabe

Der Erfindung liegt die Aufgabe zugrunde, ein verbessertes gattungsgemäßes Verfahren und ein verbessertes Gerät bereitzustellen. Insbesondere sollen das Verfahren und das Gerät derart weiterentwickelt werden, dass eine möglichst komfortable Bedienung auch bei längerer Nichtbenutzung, insbesondere eines elektrisch beheizten Bügeleisens, möglich ist.

### Erfindungsgemäße Lösung

Die der Erfindung zugrunde liegende Aufgabe wird bei einem gattungsgemäßen Verfahren dadurch gelöst, dass die Zeitdauer einer ersten Nichtbenutzung gemessen und mit einem zweiten zeitlichen Schwellenwert verglichen wird, und bei einer auf die erste Nichtbenutzung folgenden zweiten Nichtbenutzung die Deaktivierung nach Erreichen des ersten zeitlichen Schwellenwertes S1 nur erfolgt, wenn die Zeitdauer der ersten Nichtbenutzung den zweiten zeitlichen Schwellenwert nicht überstiegen hat.

Hinsichtlich des elektrisch beheizbaren Geräts der eingangs genannten Art erfolgt die Lösung dieser Aufgabe dadurch, dass das Gerät ein Zeitglied zur Bestimmung der Zeitdauer der Nichtbenutzung gemäß dem erfindungsgemäßen Verfahren aufweist.

Durch die Erfindung kann verhindert werden, dass in solchen Fällen, in denen die erste Nichtbenutzung so lange andauerte, dass das Gerät bereits sehr stark abgekühlt ist (Zeitdauer der ersten Nichtbenutzung gleich oder größer als der zweite zeitliche Schwellenwert), das Abschalten bei der zweiten Nichtbenutzung so früh erfolgt, dass das Gerät keine Gelegenheit hatte, sich wieder bis zur Betriebstemperatur aufzuheizen. Stattdessen kann erreicht werden, dass das Bügeleisen bei der zweiten Nichtbenutzung erst abschaltet, wenn vorher die Betriebstemperatur erreicht ist, und zwar selbst dann, wenn die Benutzung zwischen der ersten und der zweiten Nichtbenutzung nur sehr kurz erfolgt. Hierdurch kann der Komfort bei der Handhabung des elektrisch beheizbaren Geräts deutlich verbessert werden.

Im Sinne der vorliegenden Erfindung heißt "Nichtbenutzung", dass ein Sensor des Geräts einen Betriebszustand feststellt, der darauf hindeutet, dass das Gerät gegenwärtig nicht für den vorgesehenen Gebrauch eingesetzt wird. So kann beispielsweise eine Nichtbenutzung vorliegen, wenn ein Berührungssensor des Geräts keine Berührung eines Handgriffs des Geräts erkennt. Eine Nichtbenutzung kann auch vorliegen, wenn ein Positionssensor eine Stellung order Orientierung des Geräts feststellt, die für eine Nichtbenutzung typisch ist, z.B. eine Seitenlage eines üblicherweise nicht in Seitenlage benutzten Bügeleisens. Eine Nichtbenutzung kann auch vorliegen, wenn ein Bewegungssensor eine Ruhe des Geräts, z.B. eines Bügeleisens, feststellt.

Soweit im Zusammenhang mit dieser Erfindung von "erster" oder "zweiter" Nichtbenutzung die Rede ist, so geschieht dies lediglich, um zwischen diesen beiden Nichtbenutzungen zu unterscheiden. Die "erste Nichtbenutzung" ist also nicht notwendigerweise eine erste Nichtbenutzung im zeitlichen Sinne, d.h. es kann eine oder mehrere Nichtbenutzungen vor dieser "ersten Nichtbenutzung" geben. Gleiches gilt für die "zweite Nichtbenutzung". Allerdings liegt die "zweite Nichtbenutzung" wie unten genauer ausgeführt zeitlich nach der "ersten Nichtbenutzung". Demgemäß kann (vorzugsweise soll) jede Nichtbenutzung, auf die eine weitere Nichtbenutzung folgt, eine "erste Nichtbenutzung" im Sinne der Erfindung sein, und jede Nichtbenutzung, die auf eine andere Nichtbenutzung folgt, eine "zweite Nichtbenutzung". Insbesondere kann deshalb eine "erste Nichtbenutzung" auch gleichzeitig eine "zweite Nichtbenutzung" sein.

Dass das Gerät "eine Betriebstemperatur erreicht" hat, bedeutet Im Sinne der vorliegenden Erfindung, dass eine Komponente des Geräts, deren Temperatur zur gewöhnlichen Benutzung des Geräts geregelt wird, z.B. die Bügelsohle eines Bügeleisens, eine angestrebte Betriebstemperatur erreicht hat. Vorzugsweise ist diese Betriebstemperatur am Gerät einstellbar. So ist bei einem bevorzugten Bügeleisen eine von mehreren Temperaturstufen an einem dafür vorgesehenen Einstellmittel wählbar.

Ein "Deaktivieren" der Heizung des Geräts bedeutet im Sinne der vorliegenden Erfindung, dass die Heizung keine weitere Wärme erzeugen kann. Vorzugsweise wird dies dadurch erreicht, dass eine Stromzufuhr zu der Heizung unterbrochen wird. Umgekehrt bedeutet, dass die Heizung nicht "deaktiviert" ist, jedoch noch nicht, dass sie zwangsläufig heizt. Vielmehr ist in typischen Geräten zusätzlich zu den erfindungsgemäßen Mitteln ein Thermostat vorgesehen, der die Heizung ausschalten kann, selbst wenn sie nicht deaktiviert im Sinne der Erfindung ist. Dies erfolgt gewöhnlich, wenn eine gewünschte Betriebstemperatur erreicht ist und deshalb kein weiteres Aufheizen des Geräts erwünscht ist. Soweit das Thermostat die Stromzufuhr zu der Heizung zu Regelungszwecken unterbrechen oder drosseln kann, sind solche Unterbrechungs- oder Drosselungsmittel vorzugsweise mit einem Mittel zur erfindungsgemäßen Deaktivierung der Heizung elektrisch in Reihe geschaltet.

Die Erfindung kann insbesondere bei Haushaltsgeräten, z.B. Bügeleisen, Anwendung finden, es kommen jedoch auch andere elektrisch beheizbare Geräte in Betracht, beispielsweise Lockenstäbe, Lötkolben oder dergleichen.

Das erfindungsgemäße Verfahren ist vorzugsweise so ausgestaltet, und die erfindungsgemäße Vorrichtung so ausgebildet, dass die Heizung während einer Benutzung des Geräts aktiviert ist. "Benutzung" heißt im Sinne der vorliegenden Erfindung, dass ein Sensor des Geräts einen Betriebszustand feststellt, der darauf hindeutet, dass das Gerät gegenwärtig für den vorgesehenen Gebrauch eingesetzt wird. Vorzugsweise ist das Gerät genau dann in "Nichtbenutzung", wenn es nicht in "Benutzung" ist. Es sind aber auch Ausführungen der Erfindung denkbar, in denen es neben den Zuständen "Benutzung" und "Nichtbenutzung" noch einen dritten Zustand gibt, z.B. "Gefahr". Bei einem Bügeleisen könnte ein solcher "Gefahr"-Zustand z.B. vorliegen, wenn der Sensor eine gekippte Stellung feststellt, die darauf hindeutet, dass das Bügeleisen umgefallen sein könnte. Die Detektion einer solchen Stellung könnte z.B. ein sofortiges deaktivieren der Heizung bewirken, um Gefahren vorzubeugen.

Die Heizung ist im Sinne der vorliegenden Erfindung genau dann "aktiviert", wenn sie nicht "deaktiviert" ist.

Mit Vorteil beträgt der erste zeitliche Schwellenwert bis zur Deaktivierung der elektrischen Heizung weniger als 30 Sekunden, besonders vorzugsweise weniger als 20 Sekunden. Vorzugsweise beträgt der erste zeitliche Schwellenwert bis zur Deaktivierung der elektrischen Heizung mehr als 5 Sekunde, zum Beispiel 10 Sekunden. Durch einen nicht zu großen ersten zeitlichen Schwellenwert kann eine besonders sichere Handhabung des elektrisch beheizbaren Geräts bewirkt werden. Durch einen nicht zu kleinen ersten zeitlichen Schwellenwert kann verhindert werden, dass eine Deaktivierung schon erfolgt, wenn lediglich eine kurzzeitige Nichtbenutzung erkannt wird. Eine solche lediglich kurzzeitige Nichtbenutzung kann beispielsweise erfolgen, wenn ein Berührungssensor des Geräts keine Berührung eines Handgriffs des Geräts oder ein Bewegungssensor eine Ruhe des Geräts lediglich deshalb erkennt, weil der Benutzer gerade von einer Handhaltung zu einer anderen Handhaltung umgreift. In solchen Fällen könnte eine Deaktivierung der Heizung unerwünscht sein.

Weiterhin ist bevorzugt, dass der zweite zeitliche Schwellenwert mehr als 3 Minuten und insbesondere mehr als 7 Minuten beträgt, zum Beispiel 10 Minuten. Durch dieses Vorgehen kann sichergestellt werden, dass die Heizung nur dann bei einer auf die erste Nichtbenutzung folgenden zweiten Nichtbenutzung nach der Zeitdauer S2 deaktiviert wird, wenn das Gerät noch nicht so weit abgekühlt ist, dass ein längeres Aufheizen bis zum Erreichen der Betriebstemperatur erforderlich wäre. Vorzugsweise beträgt der zweite zeitliche Schwellenwert weniger als 30 Minuten, besonders vorzugsweise weniger als 20 Minuten.

Darüber hinaus wird vorzugsweise jede Zeit vor dem Anschließen des elektrischen Geräts an eine Stromquelle beispielsweise durch Einstecken des Netzkabels, als eine Nichtbenutzung mit einer Zeitdauer, die den ersten Schwellenwert übersteigt, angesehen. Hierdurch ist erreichbar, dass beim Anschließen des Geräts nach längerem Nichtgebrauch auch dann ein Aufheizen auf die Betriebstemperatur sichergestellt wird, wenn es schon nach einer sehr kurzen Zeit der Benutzung in den Nichtbenutzungszustand übergeht.

In einer Ausführung der Erfindung wird bei einer auf ein Anschließen des elektrischen Geräts an eine Stromquelle, beispielsweise durch Einstecken des Netzkabels, oder Anschalten des Geräts, z.B. Mittels eines Ein-/Ausschalters, folgenden Nichtbenutzung die elektrische Heizung nicht deaktiviert, bevor das Gerät eine vorgesehene Betriebstemperatur erreicht hat. Besonders vorzugsweise wird die Heizung deaktiviert, wenn das Gerät eine vorgesehene Betriebstemperatur erreicht hat. Entsprechend wird in einer Ausführung der Erfindung in dem Fall, dass die Zeitdauer der ersten Nichtbenutzung den zweiten zeitlichen Schwellenwert überstiegen hat, bei einer auf die erste Nichtbenutzung folgenden zweiten Nichtbenutzung die elektrische Heizung nicht deaktiviert, bevor es eine vorgesehene Betriebstemperatur erreicht hat. Besonders vorzugsweise wird die Heizung deaktiviert, wenn das Gerät eine vorgesehene Betriebstemperatur erreicht hat. Die vorgesehene Betriebstemperatur ist vorzugsweise am Gerät einstellbar, z.B. an einem Betriebstemperaturwählschalter oder -regler. Das Erreichen der Betriebstemperatur kann zum Beispiel durch einen Thermostat des Geräts festgestellt werden, der mit einem Mittel zur Deaktivierung funktionsverbunden ist.

Das Aufheizen des elektrisch beheizbaren Geräts auf Betriebstemperatur kann nach einer anderen Ausbildung des erfindungsgemäßen Verfahrens in besonders einfacher Weise zeitgesteuert bis zum Erreichen eines dritten zeitlichen Schwellenwerts erfolgen. Mit anderen Worten, bei einer auf ein Anschließen des elektrischen Geräts an eine Stromquelle oder Anschalten des Geräts folgenden Nichtbenutzung wird die elektrische Heizung deaktiviert, wenn die Zeitdauer der Nichtbenutzung einen dritten zeitlichen Schwellenwert erreicht hat, der größer als der erste zeitliche Schwellenwert ist. Analog wird in einer Ausbildung der Erfindung in dem Fall, dass die Zeitdauer der ersten Nichtbenutzung den zweiten zeitlichen Schwellenwert überstiegen hat, bei einer auf die erste Nichtbenutzung folgenden zweiten Nichtbenutzung die elektrische Heizung deaktiviert, wenn die Zeitdauer der Nichtbenutzung einen dritten zeitlichen Schwellenwert erreicht hat, der größer als der erste zeitliche Schwellenwert ist.

Es sind auch Ausführungen der Erfindung denkbar, bei denen der dritte zeitliche Schwellenwert mit der Zeitdauer seit der der Nichtbenutzung vorangehenden Benutzungsaufnahme verglichen wird. Vorteilhafterweise wird die Heizung in dieser Ausführung der Erfindung deaktiviert, wenn sie zuvor eine Zeitdauer aktiviert war, die mindestens dem dritten zeitlichen Schwellenwert entspricht.

Mit Vorteil beträgt der dritte zeitliche Schwellenwert bis zur Deaktivierung der elektrischen Heizung weniger als 3 Minuten, besonders vorzugsweise weniger als 2½ Minuten. Der bevorzugte dritte zeitliche Schwellenwert beträgt mehr als 1 Minute, besonders vorzugsweise mehr als 1½ Minuten, z.B. 2 Minuten.

Das erfindungsgemäße Gerät ist vorzugsweise mit einem Mittel zum Vergleich der Zeitdauer der Nichtbenutzung mit einem ersten zeitlichen Schwellenwert und einem Mittel zum Vergleich der Zeitdauer der Nichtbenutzung mit einem zweiten zeitlichen Schwellenwert ausgestattet. Die Schwellenwerte sind vorzugsweise in einem Speichermittel des Geräts abgelegt. Das bevorzugte Gerät ist außerdem mit einem Mittel zum Vergleich der Zeitdauer der Nichtbenutzung mit einem dritten zeitlichen Schwellenwert ausgestattet, wobei der dritte Schellenwert ebenfalls in einem Speichermittel abgelegt ist.

Die Nichtbenutzung bzw. Benutzung wird vorzugsweise mit einem Sensor detektiert. Der Sensor kann z.B. ein Berührungssensor sein, der vorzugsweise an einem Griffstück des Geräts angeordnet ist, um eine Berührung des Griffstücks zu erkennen. Z.B. kann der Berührungssensor ein kapazitativer Sensor sein oder ein Sensor, der einen Hautwiderstand detektiert. Auch ein Näherungssensor käme in Frage, der die Nähe einer Hand des Benutzers zu dem Griffstück detektiert. Als Sensor kommt auch ein Positionssensor in Frage, der eine Stellung order Orientierung des Geräts feststellt. Ein solcher Sensor könnte z.B. eine für die Nichtbenutzung typisch Seitenlage von einer für die Benutzung typischen aufrechten Stellung unterscheiden. Auch ein Bewegungssensor, z.B. ein Beschleunigungssensor, kommt als Sensor in Frage, der eine Ruhe des Geräts von einer Bewegung unterscheiden kann.

### Kurzbeschreibung der Figuren

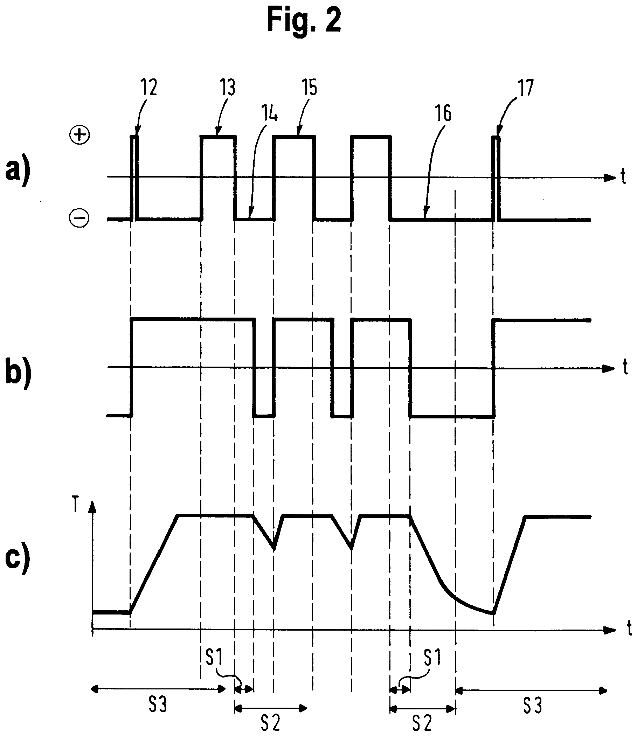

Die Erfindung wird im Folgenden anhand schematischer Zeichnungen an einem Ausführungsbeispiel mit weiteren Einzelheiten näher erläutert. Die zeitlichen Schwellenwerte S1, S2 und S3 sind in Fig. 2 aus zeichnerischen Gründen nicht im gleichen Maßstab dargestellt.

Es zeigen:
- Fig. 1:: eine perspektivische Ansicht eines erfindungsgemäßen Bügeleisens,
- Fig. 2:: den zeitlichen Verlauf der Benutzung (Fig. 2a), der Stromzufuhr (Fig. 2b) und der Temperatur (Fig. 2c) bei Anwendung des erfindungsgemäßen Verfahrens bei einem Bügeleisen.

### Ausführliche Beschreibung der Erfindung anhand eines Ausführungsbeispiels

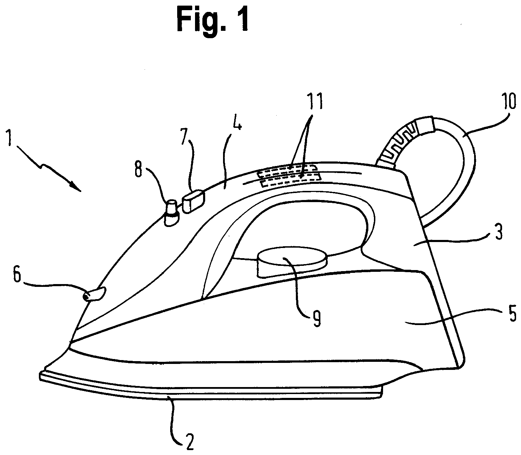

Das in Fig. 1 dargestellte, zur manuellen Bedienung vorgesehene Bügeleisen 1 besteht aus einer aus Aluminium gefertigten, planen und glatten Grundplatte 2 als Bügelsohle, welche zum Glätten eines Textils oder dergleichen auf dieses aufgesetzt wird und von seiner Oberseite her durch eine nicht sichtbare, elektrische Widerstandsheizung erhitzt wird. Die Grundplatte 2 ist thermisch isoliert an einem aus Kunststoff spritzgegossenen Gehäuse 3 angeordnet. Das Gehäuse 3 weist oberseitig ein Griffstück 4 auf, welches während des Bügelvorgangs von der Hand der Bedienperson umgriffen wird. Das Gehäuse 3 weist ferner einen Tank 5 zur Bereitstellung von Wasser für die Dampferzeugung und eine Spritzdüse 6 auf, deren Pumpe durch einen im Bereich des Griffstücks 4 angeordneten Druckknopf 7 betätigt wird. Das Gehäuse 3 ist außerdem mit Bedieneinrichtungen 8, 9 für die Einstellung der Dampferzeugung und der durch einen Thermostaten geregelten Bügeltemperatur versehen. Ein in das Gehäuse 3 einmündendes Netzkabel 10 kann über einen nicht gezeigten Stecker mit der Steckdose eines üblichen 230V Wechselspannungsnetzes verbunden werden, welches die Heizung und andere elektrische Komponenten des Bügeleisens mit elektrischer Energie speist. Innerhalb des Gehäuses 3 ist ferner eine elektronische Steuerung angeordnet.

Am Griffstück 4 ist ein berührungsempfindlicher Sensor 11 vorgesehen, der beispielsweise zur Bestimmung des Hautwiderstands geeignet ist und bei einer Berührung des Griffstücks 4 durch die Bedienperson eine Benutzung signalisiert. Löst sich die Hand der Bedienperson vom Griffstück, erlischt das Benutzungssignal und wird somit durch eine Nichtbenutzung signalisiert. Die Signale werden vom Sensor 11 an die Steuerung des Bügeleisens 1 übermittelt.

Fig. 2a zeigt einen typischen zeitlichen Verlauf (Zeit t) während des Arbeitens mit einem Bügeleisen 1. Dabei ist die Nichtbenutzung mit einem "Minus (-)" und die Benutzung mit einem "Plus (+)" gekennzeichnet.

Nach der Verbindung des Bügeleisens 1 mit dem Stromnetz wird der erstmalige Aufheizvorgang durch eine kurze Berührung des Sensors 11 durch die Bedienperson eingeleitet (Signal 12). Alternativ kann der erstmalige Aufheizvorgang auch unmittelbar durch die Netzverbindung erfolgen. Wie aus Fig. 2b ersichtlich, wird die elektrische Widerstandsheizung infolge dieses Benutzungssignals (Signal 12) eingeschaltet, wodurch die in Fig. 2c dargestellte Temperatur T in der Grundplatte 2 bis auf den gewählten Sollwert (Betriebstemperatur) ansteigt. Der Aufheizvorgang wird, sofern das Bügeleisen 1 nach der Berührung nicht weiter in Benutzung genommen wird, nur bis zum Erreichen eines zeitlichen Schwellenwertes S3, beispielsweise 2 Minuten, fortgeführt, der zum Erreichen der Betriebstemperatur ausreichend ist. Schwankungen des Verlaufs der Betriebstemperatur infolge der Tätigkeit des Thermostaten sind in der zeichnerischen Darstellung vernachlässigt.

Im Ausführungsbeispiel nimmt die Bedienperson bereits vor dem Erreichen des zeitlichen Schwellenwerts S3 die Bügeltätigkeit auf, wobei das Griffstück 4 des Bügeleisens 1 gefasst und eine weitere Benutzungskennung (Signal 13) erzeugt wird. Da der Bügelvorgang eine gewisse Zeit in Anspruch nimmt, ist das Signal 13 für die Benutzungskennung blockartig ausgebildet.

Bei einer kürzeren Unterbrechung des Bügelvorgangs und dem damit verbundenen Loslassen des Griffstücks 4, beispielsweise bei einem Wechsel des Bügelguts, wird eine Nichtbenutzung signalisiert (Signal 14), deren Dauer gemessen und mit zeitlichen Schwellenwerten S1 und S2 verglichen wird. Nach Erreichen des ersten zeitlichen Schwellenwerts S1, der beispielsweise 10 Sekunden beträgt, wird die Stromzufuhr zu der elektrischen Heizung des Bügeleisens unterbrochen, wodurch die Temperatur in der Grundplatte 2 langsam abnimmt. Im Ausführungsbeispiel nimmt die Bedienperson das Griffstück 4 bereits vor Erreichen des zeitlichen Schwellenwerts S2, der im Beispiel 10 Minuten beträgt, wieder in die Hand, wodurch erneut eine blockartige Benutzungskennung (Signal 15) erzeugt und die elektrische Heizung aktiviert wird, solange die Hand der Bedienperson am Griffstück 4 verbleibt. Ein solcher Ablauf wiederholt sich üblicherweise mehrmals.

Bei einer längeren Unterbrechung hingegen wird eine andauernde Nichtbenutzung signalisiert (Signal 16), deren Dauer zunächst ebenfalls den ersten zeitlichen Schwellenwert S1 übersteigt und damit zu einer Unterbrechung der Stromzufuhr zur Heizung führt. Die Dauer des Signals 16 übersteigt nun aber auch den zweiten zeitlichen Schwellenwert S2. Nachfolgend ist bereits, wie beim erstmaligen Anschluss an das Stromnetz, eine kurze, impulsartige Berührung des Griffstücks 4 ausreichend (Signal 17), um die Grundplatte 2 des Bügeleisens wieder auf Betriebstemperatur aufzuheizen. Dem steht nicht entgegen, dass die Bedienperson das Griffstück 4 während des Aufheizvorgangs konstant greift, allerdings ist dies zur Verbesserung des Bedienkomforts nicht zwingend erforderlich.

Durch die Erfindung kann der Bügelkomfort wesentlich gesteigert werden. Insbesondere kann vermieden werden, dass bei einer auf eine längere Nichtbenutzung folgenden kurzzeitigen Benutzung das Gerät nicht für die weitere Benutzung ausreichend aufgeheizt wird.

Die in der vorstehenden Beschreibung, den Ansprüchen und den Zeichnungen offenbarten Merkmale können sowohl einzeln als auch in beliebiger Kombination für die Verwirklichung der Erfindung in ihren verschiedenen Ausgestaltungen von Bedeutung sein.

### Bezugszeichen

- 1: Bügeleisen
- 2: Grundplatte
- 3: Gehäuse
- 4: Griffstück
- 5: Tank
- 6: Spritzdüse
- 7: Druckknopf
- 8: Bedieneinrichtung
- 9: Bedieneinrichtung
- 10: Netzkabel
- 11: Sensor
- 12: Signal (impulsartige Benutzungskennung)
- 13: Signal (blockartige Benutzungskennung)
- 14: Signal (kurz andauernde Nichtbenutzungskennung)
- 15: Signal (blockartige Benutzungskennung)
- 16: Signal (lang andauernde Nichtbenutzungskennung)
- 17: Signal (impulsartige Benutzungskennung)

- S1: erster zeitlicher Schwellenwert
- S2: zweiter zeitlicher Schwellenwert
- S3: dritter zeitlicher Schwellenwert
- t: Zeit
- T: Temperatur
- ⊕: Benutzung
- ⊖: Nichtbenutzung

## Patentansprüche

1. Verfahren zur Steuerung eines elektrisch beheizbaren Geräts (1), bei dem in
Abhängigkeit von einem Benutzungszustand des Geräts (1) eine Nichtbenutzung ermittelt wird und die elektrische Heizung des Geräts (1) deaktiviert werden kann, wenn die Zeitdauer der Nichtbenutzung einen ersten zeitlichen Schwellenwert (S1) erreicht hat, **dadurch gekennzeichnet, dass** die Zeitdauer einer ersten Nichtbenutzung gemessen und mit einem zweiten zeitlichen Schwellenwert (S2) verglichen wird, und bei einer auf die erste Nichtbenutzung folgenden zweiten Nichtbenutzung die Deaktivierung nach Erreichen des ersten zeitlichen Schwellenwerts (S1) nur erfolgt, wenn die Zeitdauer der ersten Nichtbenutzung den zweiten zeitlichen Schwellenwert (S2) nicht überstiegen hat.

2. Verfahren nach Anspruch 1, **dadurch gekennzeichnet, dass** der erste zeitliche Schwellenwert (S1) für die zweite Nichtbenutzung weniger als 30 Sekunden oder weniger als 20 Sekunden und mehr als 5 Sekunden oder 10 Sekunden beträgt.

3. Verfahren nach einem der vorherigen Ansprüche, **dadurch gekennzeichnet, dass** der zweite zeitliche Schwellenwert (S2) mehr als 3 Minuten oder mehr als 5 Minuten oder mehr als 7 oder 10 Minuten und weniger als 30 Minuten oder weniger als 20 Minuten beträgt.

4. Verfahren nach einem der vorhergehenden Ansprüche, **dadurch gekennzeichnet, dass** bei einer auf ein Anschließen des elektrischen Geräts (1) an eine Stromquelle oder ein Anschalten des Geräts (1) folgenden Nichtbenutzung die elektrische Heizung nicht deaktiviert wird, bevor das Gerät (1) eine vorgesehene Betriebstemperatur erreicht hat.

5. Verfahren nach einem der vorhergehenden Ansprüche, **dadurch gekennzeichnet,**
**dass** bei einer auf ein Anschließen des elektrischen Geräts (1) an eine Stromquelle oder ein Anschalten des Geräts (1) folgenden Nichtbenutzung die elektrische Heizung deaktiviert wird, wenn die Zeitdauer der Nichtbenutzung einen dritten zeitlichen Schwellenwert (S3) erreicht hat, der größer als der erste zeitliche Schwellenwert (S1) ist.

6. Verfahren nach einem der vorhergehenden Ansprüche, **dadurch gekennzeichnet, dass** in dem Fall, dass die Zeitdauer der ersten Nichtbenutzung den zweiten zeitlichen Schwellenwert (S2) überstiegen hat, bei einer auf die erste Nichtbenutzung folgenden zweiten Nichtbenutzung die elektrische Heizung nicht deaktiviert wird, bevor eine an dem Gerät (1) vorgesehene Betriebstemperatur erreicht ist.

7. Verfahren nach einem der vorhergehenden Ansprüche, **dadurch gekennzeichnet, dass** in dem Fall, dass die Zeitdauer der ersten Nichtbenutzung den zweiten zeitlichen Schwellenwert (S2) überstiegen hat, bei einer auf die erste Nichtbenutzung folgenden zweiten Nichtbenutzung die elektrische Heizung deaktiviert wird, wenn die Zeitdauer der Nichtbenutzung einen dritten zeitlichen Schwellenwert (S3) erreicht hat, der größer als der erste zeitliche Schwellenwert (S1) ist.

8. Verfahren nach einem der Anspruch 5 oder 7, **dadurch gekennzeichnet, dass** der dritte zeitliche Schwellenwert (S3) mehr als 1 Minute oder mehr als 1,5 Minuten oder 2 Minuten beträgt.

9. Elektrisch beheizbares Gerät (1), insbesondere Haushaltsgerät, mit einer elektrischen Heizung und einer mit dieser zusammenwirkenden elektrischen Schaltung sowie mit einem Sensor (11) zur Erkennung einer Nichtbenutzung, wobei die elektrische Schaltung ein Zeitglied aufweist, welches zur Bestimmung der Zeitdauer der Nichtbenutzung und deren Vergleich mit einem ersten zeitlichen Schwellenwert (S1) geeignet ist, **dadurch gekennzeichnet, dass** das Gerät (1) ein Zeitglied zur Bestimmung der Zeitdauer der Nichtbenutzung gemäß dem Verfahren nach einem der vorherigen Ansprüche aufweist.

10. Elektrisch beheizbares Gerät (1) nach Anspruch 9, **dadurch gekennzeichnet, dass** es Mittel zum Vergleich der Zeitdauer der Nichtbenutzung mit einem ersten zeitlichen Schwellenwert (S1) aufweist.

11. Elektrisch beheizbares Gerät (1) nach Anspruch 9 oder 10, **dadurch gekennzeichnet, dass** es Mittel zum Vergleich der Zeitdauer der Nichtbenutzung mit einem zweiten zeitlichen Schwellenwert (S2) aufweist.

12. Elektrisch beheizbares Gerät (1) nach einem der Ansprüche 9 bis 11, **dadurch gekennzeichnet, dass** es Mittel zum Vergleich der Zeitdauer der Nichtbenutzung mit einem dritten zeitlichen Schwellenwert (S3) aufweist.

13. Elektrisch beheizbares Gerät (1) nach einem der Ansprüche 9 bis 12, **dadurch gekennzeichnet, dass** der Sensor (11) als berührungsempfindlicher Schalter im Griffstück (4) des Geräts (1) ausgebildet ist.

14. Elektrisch beheizbares Gerät (1) nach einem der Ansprüche 9 bis 12, **dadurch gekennzeichnet, dass** der Sensor (11) als Bewegungssensor ausgebildet ist.

## Claims

1. Method for controlling an electrically heatable device (1), in which non-usage is determined as a function of a usage state of the device (1) and the electric heater of the device (1) can be deactivated if the duration of non-usage has reached a first temporal threshold value (S1), **characterised in that** the duration of a first non-usage is measured and compared to a second temporal threshold value (S2), and during a second non-usage following on from the first non-usage, the deactivation will occur after the first temporal threshold value (S1) is reached only if the duration of the first non-usage has not exceeded the second temporal threshold value (S2).

2. Method according to claim 1, **characterised in that** the first temporal threshold value (S1) for the second non-usage is less than 30 seconds or less than 20 seconds and more than 5 seconds or 10 seconds.

3. Method according to one of the preceding claims, **characterised in that** the second temporal threshold value (S2) is more than 3 minutes or more than 5 minutes or more than 7 or 10 minutes and less than 30 minutes or less than 20 minutes.

4. Method according to one of the preceding claims, **characterised in that** in the case of non-usage following on from a connection of the electrical device (1) to a power source or a power-on of the device (1) the electric heater is not deactivated before the device (1) has reached a designated operating temperature.

5. Method according to one of the preceding claims, **characterised in that** in the case of non-usage following on from a connection of the electrical device (1) to a power source or a power-on of the device (1) the electric heater is deactivated if the duration of non-usage has reached a third temporal threshold value (S3) which is greater than the first temporal threshold value (S1).

6. Method according to one of the preceding claims, **characterised in that** in the event that the duration of the first non-usage has exceeded the second temporal threshold value (S2), in the case of a second non-usage following on from the first non-usage the electric heater is not deactivated before an operating temperature designated on the device (1) is reached.

7. Method according to one of the preceding claims, **characterised in that** in the event that the duration of the first non-usage has exceeded the second temporal threshold value (S2), in the case of a second non-usage following on from the first non-usage the electric heater is is deactivated if the duration of non-usage has reached a third temporal threshold value (S3) which is greater than the first temporal threshold value (S1).

8. Method according to one of claims 5 or 7, **characterised in that** the third temporal threshold value (S3) is more than 1 minute or more than 1.5 minutes or 2 minutes.

9. Electrically heatable device (1), in particular household device, having an electric heater and an electric circuit cooperating therewith and having a sensor (11) for detection of non-usage, wherein the electric circuit has a timing element which is suitable for determining the duration of non-usage and comparing it with a first temporal threshold value (S1), **characterised in that** the device (1) has a timing element for determining the duration of non-usage in accordance with the method according to one of the preceding claims.

10. Electrically heatable device (1) according to claim 9, **characterised in that** it has means for comparing the duration of non-usage with a first temporal threshold value (S1).

11. Electrically heatable device (1) according to claim 9 or 10, **characterised in that** it has means for comparing the duration of non-usage with a second temporal threshold value (S2).

12. Electrically heatable device (1) according to one of claims 9 to 11, **characterised in that** it has means for comparing the duration of non-usage with a third temporal threshold value (S3).

13. Electrically heatable device (1) according to one of claims 9 to 12, **characterised in that** the sensor (11) is designed as a touch-sensitive switch in the handle (4) of the device (1).

14. Electrically heatable device (1) according to one of claims 9 to 12, **characterised in that** the sensor (11) is designed as a motion sensor.

## Revendications

1. Procédé de commande d'un appareil pouvant être chauffé de manière électrique (1), dans lequel une non-utilisation est déterminée en fonction d'un état d'utilisation de l'appareil (1) et le chauffage électrique de l'appareil (1) peut être désactivé si la durée de la non-utilisation a atteint une première valeur temporelle de seuil (S1), **caractérisé en ce que** la durée d'une première non-utilisation est mesurée et comparée avec une deuxième valeur temporelle de seuil (S2), et, pour une deuxième non-utilisation succédant à la première non-utilisation, la désactivation n'intervient après atteinte de la première valeur temporelle de seuil (S1) que si la durée de la première non-utilisation n'a pas dépassé la deuxième valeur temporelle de seuil (S2).

2. Procédé selon la revendication 1, **caractérisé en ce que** la première valeur temporelle de seuil (S1) pour la deuxième non-utilisation est inférieure à 30 secondes ou inférieure à 20 secondes et supérieure à 5 secondes ou est de 10 secondes.

3. Procédé selon l'une quelconque des revendications précédentes, **caractérisé en ce que** la deuxième valeur temporelle de seuil (S2) est supérieure à 3 minutes ou supérieure à 5 minutes ou supérieure à 7 ou 10 minutes et inférieure à 30 minutes ou inférieure à 20 minutes.

4. Procédé selon l'une quelconque des revendications précédentes, **caractérisé en ce que** pour une non-utilisation succédant à un raccordement de l'appareil électrique (1) à une source de courant ou à une mise en route de l'appareil (1), le chauffage électrique n'est pas désactivé avant que l'appareil (1) ait atteint une température de fonctionnement prévue.

5. Procédé selon l'une quelconque des revendications précédentes, **caractérisé en ce que** pour une non-utilisation succédant à un raccordement de l'appareil électrique (1) à une source de courant ou à une mise en route de l'appareil (1), le chauffage électrique est désactivé si la durée de la non-utilisation a atteint une troisième valeur temporelle de seuil (S3) qui est supérieure à la première valeur temporelle de seuil (S1).

6. Procédé selon l'une quelconque des revendications précédentes, **caractérisé en ce que** dans le cas où la durée de la première non-utilisation a dépassé la deuxième valeur temporelle de seuil (S2), pour une deuxième non-utilisation succédant à la première non-utilisation, le chauffage électrique n'est pas désactivé avant qu'une température de fonctionnement prévue au niveau de l'appareil (1) ne soit atteinte.

7. Procédé selon l'une quelconque des revendications précédentes, **caractérisé en ce que**, dans le cas où la durée de la première non-utilisation a dépassé la deuxième valeur temporelle de seuil (S2), pour une deuxième non-utilisation succédant à la première non-utilisation, le chauffage électrique est désactivé si la durée de la non-utilisation a atteint une troisième valeur temporelle de seuil (S3) qui est supérieure à la première valeur temporelle de seuil (S1).

8. Procédé selon la revendication 5 ou 7, **caractérisé en ce que** la troisième valeur temporelle de seuil (S3) est supérieure à 1 minute ou supérieure à 1,5 minute ou est de 2 minutes.

9. Appareil pouvant être chauffé de manière électrique (1), en particulier appareil ménager, muni d'un chauffage électrique et d'un circuit de commutation électrique collaborant avec ledit chauffage ainsi que d'un capteur (11) destiné à détecter une non-utilisation, dans lequel le circuit de commutation électrique présente un élément de temporisation qui est approprié afin de déterminer la durée de la non-utilisation et afin de comparer celle-ci avec une première valeur temporelle de seuil (S1), **caractérisé en ce que** l'appareil (1) présente un élément de temporisation destiné à déterminer la durée de la non-utilisation conformément au procédé selon l'une quelconque des revendications précédentes.

10. Appareil pouvant être chauffé de manière électrique (1) selon la revendication 9, **caractérisé en ce qu'**il présente un moyen destiné à comparer la durée de la non-utilisation avec une première valeur temporelle de seuil (S1).

11. Appareil pouvant être chauffé de manière électrique (1) selon la revendication 9 ou 10, **caractérisé en ce qu'**il présente un moyen destiné à comparer la durée de la non-utilisation avec une deuxième valeur temporelle de seuil (S2).

12. Appareil pouvant être chauffé de manière électrique (1) selon l'une quelconque des revendications 9 à 11, **caractérisé en ce qu'**il présente un moyen destiné à comparer la durée de la non-utilisation avec une troisième valeur temporelle de seuil (S3).

13. Appareil pouvant être chauffé de manière électrique (1) selon l'une quelconque des revendications 9 à 12, **caractérisé en ce que** le capteur (11) est réalisé sous forme de commutateur à effleurement situé dans la partie poignée (4) de l'appareil (1).

14. Appareil pouvant être chauffé de manière électrique (1) selon l'une quelconque des revendications 9 à 12, **caractérisé en ce que** le capteur (11) est réalisé sous forme de capteur de mouvement.
